# EUROPÄISCHE PATENTSCHRIFT

(11) **EP 1 544 982 B1**
(45) Veröffentlichungstag und Bekanntmachung des Hinweises auf die Patenterteilung: **10.03.2010**
(21) Anmeldenummer: 03029515.8
(22) Anmeldetag: 20.12.2003
(51) Int. Cl.: H02K 11/00, H02K 5/22

(54) **Klemmenkasten**
Terminal box
Boîte de bornes

(43) Veröffentlichungstag der Anmeldung: 22.06.2005
(73) Patentinhaber: GRUNDFOS A/S, 8850 Bjerringbro (DK)
(72) Erfinder: Andersen,Lars Kannegaard, 8900 Randers (DK)
(74) Vertreter: Hemmer, Arnd

(56) Entgegenhaltungen:
- EP-A- 0 751 606
- EP-A- 0 951 131
- DE-A- 4 015 080
- DE-A- 10 065 796
- DE-U- 29 880 014
- US-A- 5 194 772

## Beschreibung

Die Erfindung betrifft einen Klemmenkasten für einen Elektromotor insbesondere als Antriebseinheit eines Pumpenaggregats.

Die Klemmenkästen sind üblicherweise an der äußeren Mantelfläche eines Motorgehäuses, beispielsweise eines Pumpenaggregats, angeordnet. Sie stellen die Verbindung der Elektromotoren mit einer Stromversorgung her. Des Weiteren beinhalten sie meist die Leistungs- und Steuerungselektronik sowie die Bedienelemente der Motoren bzw. Pumpen. Bauteile der Leistungselektronik, wie z.B. ein Frequenzumwandler zur Drehzahlsteuerung des Motors, erzeugen während des Betriebs eine große Eigenwärme, welche abgeführt werden muss. Derartige Klemmenkästen gehen beispielsweise aus DE 100 65 796 A1 sowie DE 298 80 014 U1 hervor.

Hierzu beschreiben EP 0 951 131 A und DE 298 80 014 U die Anordnung von außerhalb der Klemmenkästen angeordneten Wärmeverteilern, die eine Wärmeleitung in die Gehäuse der Elektromotoren ermöglichen. Bei anderen bekannten Klemmenkästen ist ein Wärmeverteiler an einer Innenseite einer Außenwandung des Klemmenkastens angeordnet. Die Abwärme elektronischer Bauteile, die an diesem Wärmeverteiler angeordnet sind, wird so über den Wärmeverteiler durch die Außenwandung des Klemmenkastens an die Umgebungsluft abgegeben. Diese bekannten Wärmeverteiler sind an der Außenwandung angegossen der angeklebt. Das Ein- bzw. Angießen des Wärmeverteilers erfolgt bei der Herstellung des aus Kunststoff bestehenden Gehäuses des Klemmenkastens, indem das Kunststoffmaterial des Gehäuses direkt an den Wärmeverteiler angegossen wird. Diese Anordnung führt zu erheblichen Fertigungsproblemen und unerwünschten thermischen Spannungen im Klemmenkastengehäuse. Das Befestigen des Wärmeverteilers durch eine Klebverbindung bedarf eines zusätzlichen Produktionsschrittes und führt damit verbunden zu einem höheren Zeit- und Kostenaufwand bei der Montage.

EP 0 751 606 A beschreibt einen Wechselstromgenerator für Kraftfahrzeuge, bei dem an einem axialen endseitigen Lagerschild eine Stromregelung angeordnet ist. Daneben sind an dem Lagerschild zwei Kühlkörper angeordnet, die jeweils von einem Verteiler überbaut sind. Gemeinsam sind jeweils ein Kühlkörper und ein Verteiler mit dem Lagerschild verschraubt. Nachteilig ist bei dieser Anordnung, dass die Kühlkörper nur schlecht zugänglich sind und das Befestigen der Kühlkörper an dem Lagerschild sehr aufwendig ist.

Die Aufgabe der vorliegenden Erfindung ist es, einen Klemmenkasten für einen Elektromotor dahingehend zu bessern, dass die Abwärme wärmeerzeugender Bauteile ausreichend abgeführt wird, wobei die Herstellung und Montage des Klemmenkastens einfacher, d. h. zeit- und kostengünstiger erfolgen kann.

Diese Aufgabe wird durch einen Klemmenkasten mit den im Anspruch 1 angegebenen Merkmalen gelöst. Bevorzugte Ausführungsformen ergeben sich aus den Unteransprüchen.

Der erfindungsgemäße Klemmenkasten für einen Elektromotor weist zwei Gehäuseteile auf. An einer Innenwandung eines ersten Gehäuseteils ist ein Wärmeverteiler vorgesehen, um die Wärmeverluste zumindest eines elektronischen Bauteils aus dem Klemmenkasten an die Umgebungsluft abzuführen. Der Wärmeverteiler ist derart durch das erste und zweite Gehäuseteil gehalten, dass er flächig an der Innenwandung des ersten Gehäuseteils anliegt. Hierzu sind die beiden Gehäuseteile so gestaltet, dass sie den Wärmeverteiler, der zwischen ihnen lediglich lose eingelegt ist, durch ihr Zusammensetzen kraft- und/oder formschlüssig in die vorgesehene Position an der Innenwandung des ersten Gehäuseteils zwingen und ihn dort festhalten, ohne dass weitere Befestigungsarbeiten und Befestigungsmittel erforderlich sind. Der Wärmeverteiler weist eine Anlagefläche auf, welche korrespondierend zur Innenwandung des ersten Gehäuseteils ausgebildet ist, so dass die Anlagefläche zumindest abschnittsweise flächig an der Innenwandung anliegt, um einen guten Wärmeübergang zu erzielen. Der Wärmeübergang kann durch das Auftragen einer Wärmeleitpaste zwischen der Anlagefläche des Wärmeverteilers und der Innenwandung des ersten Gehäuseteils zusätzlich verbessert werden. Vorzugsweise bildet das erste Gedie vom Statorgehäuse des Motors abgewandte Außenwand des Klemmenkastens. Das zweite Gehäuseteil ist dabei zwischen dem Statorgehäuse und dem ersten Gehäuseteil angeordnet und liegt direkt an dem Statorgehäuse an. Die Montage des Klemmenkastens erfolgt bevorzugt durch das lose Einlegen des Wärmeverteilers in das erste Gehäuseteil und das anschließende Aufsetzen des zweiten Gehäuseteils auf das erste Gehäuseteil, wodurch der Wärmeverteiler zwischen den beiden Gehäuseteilen eingeklemmt und an die Innenwandung des ersten Gehäuseteils angedrückt wird.

Bevorzugt verläuft die Wandung des ersten Gehäuseteils, an welcher der Wärmeverteiler anliegt, schräg zur Fügerichtung von erstem und zweitem Gehäuseteil. Die Fügerichtung ist die Richtung, in der das erste und zweite Gehäuseteil aufeinander zu bewegt werden, um diese zusammenzufügen. Die zur Fügerichtung schräge Wandung des ersten Gehäuseteils bildet eine schiefe Ebene, über die der Wärmeverteiler beim Einsetzen in die für ihn vorgesehene Position der Wandung gleiten kann und vorzugsweise aufgrund der Schwerkraft an der Innenwandung anliegt. Die zur Fügerichtung schräge Anlagefläche des Wärmeverteilers bewirkt, dass, wenn beim Zusammensetzen der Gehäuseteile auf dem Wärmeverteiler eine Klemm- bzw. Haltekraft in Fügerichtung ausgeübt wird, gleichzeitig eine Andruckkraft an die Innenwandung des ersten Gehäuseteils erzeugt wird, welche normal zur Fügerichtung verläuft. So kann der Wärmeverteiler sicher eingeklemmt und eine flächige Anlage an der Klemmenkastenwandung gewährleistet werden. Desweiteren sind die Anbindungsorte des Wärmeverteilers an den beiden Gehäuseteilen wegen der Schräge des ersten Gehäuseteils vorzugsweise sowohl in Fügerichtung als auch normal zu dieser versetzt. Entsprechend ist der Wärmeverteiler zwischen den beiden Gehäuseteilen in Fügerichtung gehalten und wird normal zur Fügerichtung gegen die Innenwandung gedrückt, was den Formschluss und damit eine optimale Wärmeübertragung zwischen der Innenwandung des ersten Gehäuseteils und dem Wärmeverteiler gewährleistet. In einer bevorzugten Gestaltungsform wird die schräge Anlagefläche des Wärmeverteilers durch eine schalenartige Ausbildung des ersten Gehäuseteils erzeugt. Bei dieser Bauweise ist am offenen Ende des ersten Gehäuseteils eine Fügekante zum Zusammenbau mit dem zweiten Gehäuseteil vorgesehen. Dieses wird auf die Fügekante des ersten Gehäuseteils als Boden aufgesetzt, wobei die Fügerichtung senkrecht zu der Öffnungsfläche in Richtung des geschlossenen Endes des ersten Gehäuseteils verläuft.

Die Wandung, an der der Wärmeverteiler anliegt, kann ferner gewölbt ausgebildet sein, wobei der Wärmeverteiler bzw. dessen Anlagefläche eine korrespondierende Form aufweist. Beispielsweise ist das erste Gehäuseteil dergestalt gewölbt, dass es die Form eines Zylinder- bzw. Kreiszylindersegments aufweist, welches an der der Krümmung abgewandten Seite geöffnet ist. Die Öffnung verläuft somit im Querschnitt im Wesentlichen in Richtung einer Kreissehne und ist durch das zweite Gehäuseteil verschlossen. Der Rand dieser offenen Fläche bzw. Öffnung bildet eine Fügekante, an der das zweite Gehäuseteil anliegt. Die Fügerichtung verläuft vorzugsweise normal zur Längsachse des Zylindersegments und Erstreckungsrichtung der Öffnung. Der Wärmeverteiler ist an der Innenwandung des ersten Gehäuseteils bevorzugt in einem Bereich angeordnet, welcher sich ausgehend von der Fügekante erstreckt. Seine Anbindungspunkte an dem zweiten Gehäuseteil befinden sich vorzugsweise nahe der Fügekante des ersten Gehäuseteils und die Anbindungspunkte an dem ersten Gehäuseteil beabstandet von der Fügekante.

Vorteilhaft weisen das erste und das zweite Gehäuseteil jeweils zumindest ein Aufnahmeelement zum Halten des Wärmeverteilers auf. Die Aufgabe dieser Aufnahmeelemente ist es, den Wärmeverteiler so an der Innenwandung des ersten Gehäuseteils zu halten, dass der Wärmeverteiler in dieser Position möglichst spielfrei festgelegt ist und flächig anliegend an der Innenwandung des ersten Gehäuseteils gehalten wird, so dass keine zusätzlichen Befestigungsmittel benötigt werden und ein guter Wärmeübergang gewährleistet ist. Die Aufnahmeelemente sind bevorzugt als Ausnehmungen und/oder Vorsprünge einstückig mit dem ersten und zweiten Gehäuseteil ausgebildet.

Zweckmäßigerweise sind die Aufnahmeelemente der beiden Gehäuseteile so voneinander beabstandet, dass der Wärmeverteiler, wenn das erste und zweite Gehäuseteil zusammengesetzt sind, form- und/oder kraftschlüssig an die Gehäusewandung angedrückt wird. Hierzu sollte der Abstand der Aufnahmeelemente beider Gehäuseteile im zusammengebauten Zustand mit dem Abstand der zugehörigen Anbindungspunkte am Wärmeverteiler übereinstimmen, so dass eine spielfreie Halterung gewährleistet ist.

In einer bevorzugten Ausführungsform ist der Wärmeverteiler von einem von der Fügekante beabstandet angeordneten Aufnahmeelement an dem ersten Gehäuseteil gehalten. Die Anbindung des Wärmeverteilers an das zweite Gehäuseteil ist vorzugsweise nahe der gemeinsamen Seiten- bzw. Fügekante der beiden Gehäuseteile an einem Aufnahmeelement am zweiten Gehäuseteil vorgesehen. Dieses Aufnahmeelement hält den Wärmeverteiler vorteilhaft in Fügerichtung und drückt ihn normal zur Fügerichtung gegen die Innenwandung des ersten Gehäuseteils an.

Bevorzugt weist der Wärmeverteiler zumindest ein Halteelement auf, welches mit zumindest einem Aufnahmeelement eines der Gehäuseteile derart in Eingriff ist, dass das Halteelement an einer der Innenwandung des ersten Gehäuseteils zugewandten Fläche des Aufnahmeelements anliegt. Diese Ausgestaltung ermöglicht bei der aus dem Halteelement des Wärmeverteilers und dem Aufnahmeelement bestehenden Halterungspaarung die Einleitung einer Druckkraft in Richtung der Innenwandung des ersten Gehäuseteils. So wird der Wärmeverteiler über das Halteelement gegen die Innenwandung des Gehäuses gedrückt. Bevorzugt ist ein derart ausgestaltetes Halteelement mit einem korrespondierenden Aufnahmeelement zur Halterung des Wärmeverteilers an dem zweiten Gehäuseteil vorgesehen.

Beispielhaft weist der Wärmeverteiler an seinem, dem zweiten Gehäuseteil zugewandten Ende, zumindest einen nasenförmigen Vorsprung als Halteelement auf. Korrespondierend ist zumindest ein napfförmiges Aufnahmeelement am zweiten Gehäuseteil vorgesehen, welches das Halteelement vorzugsweise spielfrei aufnimmt. Dazu kann zusätzlich eine elastische Auskleidung z.B. in Form einer Dichtung in dem Aufnahmeelement angeordnet sein. Im zusammengebauten Zustand der beiden Gehäuseteile greift die Nase des Halteelements in den Napf des Aufnahmeelements ein. Dabei liegt das Halteelement mit seiner der Innenwandung des ersten Gehäuseteils abgewandten Seite an einer Fläche des Aufnahmeelements, die der Innenwandung des ersten Gehäuseteils zugewandt ist, an, so dass der Wärmeverteiler durch dieses an die Innenwandung des ersten Gehäuseteils angedrückt bzw. an dieser anliegend gehalten wird.

Vorteilhaft erstreckt sich das Aufnahmeelement an dem zweiten Gehäuseteil in Fügerichtung der beiden Gehäuseteile. Dies erleichtert das Zusammenfügen des Wärmeverteilers mit den beiden Gehäuseteilen. Bei der bevorzugten Ausführungsform, in der die Wandung des ersten Gehäuseteils schräg zur Fügerichtung der beiden Gehäuseteile verläuft und damit auch der Wärmeverteiler schräg zu dieser Fügerichtung angeordnet ist, kann durch Kontakt des Aufnahmeelements mit dem schräg zu diesem liegenden Wärmeverteiler bzw. dessen entsprechend gerichteten Halteelement eine schräg zur Fügerichtung und normal zur Innenwandung des ersten Gehäuseteils gerichtete Andruckkraft erzeugt werden. In zwei Komponenten zerlegt, wirkt eine erste Kraftkomponente in Fügerichtung und fixiert den Wärmeverteiler in dieser Richtung zwischen den beiden Gehäuseteilen. Eine zweite Kraftkomponente wirkt normal zur Fügerichtung auf die Innenwandung des ersten Gehäuseteils zu. Diese Kraftkomponente bewirkt die Anlage zwischen dem Wärmeverteiler und der Innenwandung des ersten Gehäuseteils.

Zweckmäßigerweise ist das Aufnahmeelement am ersten Gehäuseteil von dessen Fügekante mit dem zweiten Gehäuseteil beabstandet. Das Aufnahmeelement ist von der Seiten- bzw. Fügekante so weit entfernt angeordnet, dass für den Wärmeverteiler eine genügend große Auflagefläche zur Verfügung steht. Weist das erste Gehäuseteil eine schräge Gehäusewand zur Anbindung des Wärmeverteilers auf, ist das Aufnahmeelement des ersten Gehäuseteils aufgrund der Schräge der Gehäusewand bezogen auf die Position des Aufnahmeelements des zweiten Gehäuseteils normal zur Fügerichtung der beiden Gehäuseteile versetzt angeordnet. Dies erleichtert das Andrücken des Wärmeleiters an die Innenwandung des ersten Gehäuseteils.

Bevorzugt ist in einem der Gehäuseteile ein vorzugsweise federnd ausgebildeter Kontakt eines elektrischen Schutzleiters angeordnet, an welchem ein Kontaktbereich des Wärmeverteilers anliegt. Auf diese Weise ist der Wärmeverteiler geerdet, beispielsweise zur Abschirmung elektronischer Bauteile, welche an dem Wärmeverteiler angeordnet sind. Die direkte Anbindung des Wärmeverteilers an den Kontakt des elektrischen Schutzleiters ermöglicht eine einfache Kontaktierung, bei der keine zusätzlichen elektrisch leitende Verbindungselemente, wie z.B. Kabel, die angeklemmt werden müssen, erforderlich sind. Der Kontakt zwischen dem Schutzleiter und dem Wärmeverteiler wird durch die Einbaulage des Wärmeverteilers zwischen den beiden Gehäuseteilen hergestellt, in der der Wärmeverteiler durch die Gehäuseteile gegen den Kontakt gedrückt wird. Die federnde Ausgestaltung des Kontakts ermöglicht es, eventuelle Wärmeausdehnungen des Wärmeverteilers, Fertigungstoleranzen etc. auszugleichen und immer einen sicheren Kontakt zu gewährleisten.

Vorteilhaft ist der Kontaktbereich des Wärmeverteilers als Arm ausgebildet, welcher sich quer zur Fügerichtung von erstem und zweitem Gehäuseteil erstreckt. Der Arm kann einen Abstand zwischen dem Wärmeverteiler und dem Kontakt des elektrischen Schutzleiters in Form einer starren Verbindung überbrücken. Da der Wärmeleiter vorzugsweise als metallisches Gussteil vorgesehen ist, kann der armförmige Kontaktbereich integral am Wärmeverteiler angeordnet sein und in einem Fertigungsschritt mit diesem hergestellt werden. In der bevorzugten Ausführungsform, in der an dem ersten Gehäuseteil eine schräge Anlagefläche für den Wärmeverteiler vorgesehen ist, wird der Arm in seiner Längsrichtung gegen den Kontakt gedrückt.

Zweckdienlich stützt sich der Wärmeverteiler an der Innenwand des ersten Gehäuseteils anliegend an dem Aufnahmeelement und dem an einem der Gehäuseteile vorgesehenen Kontakt des elektrischen Schutzleiters ab. Auf diese Weise ist eine Anlage des Wärmeverteilers an dem Kontakt des elektrischen Schutzleiters immer gewährleistet und somit seine Erdung sichergestellt. Beispielsweise liegt die Seitenkante des Wärmeverteilers an dem Aufnahmeelement des ersten Gehäuseteils auf und eine Kante oder der Arm des Kontaktbereichs des Wärmeverteilers an dem Kontakt des elektrischen Schutzleiters an. Der Wärmeverteiler ist durch diese Abstützung in seiner vorgesehenen Position angeordnet.

Bevorzugt sind die beiden Gehäuseteile als Kunststoffspritzgussteile ausgebildet, während der Wärmeverteiler, der an der Innenwandung des ersten Gehäuseteils anliegt, aus einem metallischen Material besteht. Dabei kann der Wärmeverteiler so geformt sein, dass er sich aufgrund der unterschiedlichen Wärmeausdehnung der beiden Materialien während des Betriebs weiter der Form der Innenwandung des ersten Gehäuseteils anpasst, wodurch die Anlage zwischen dem Wärmeverteiler und der Innenwandung des ersten Gehäuseteils nochmals verbessert wird. Beispielseise biegt sich ein gekrümmter Wärmeverteiler bei Erwärmung stärker auf, als die korrespondierend geformte Wandung des ersten Gehäuseteils, so dass sich die Andruckkraft, mit der der Wärmeverteiler gegen die Wandung gedrückt wird, verstärkt.

Der Klemmenkasten wird vorzugsweise für einen nasslaufenden Motor eines Pumpenaggregats verwendet. Dabei ist an dem Klemmenkasten ein erster Wärmeverteiler, an dem Bauteile der Leistungselektronik eines Frequenzumrichters angeordnet sind, vorgesehen. Der Wärmeverteiler weist einen wärmeleitenden Kontakt zu dem Statorgehäuse des Motors auf, über den er seine Wärme in den flüssigkeitsgekühlten Motor abführt. Für weitere wärmeerzeugende elektronische Komponenten, wie z.B. einen Zwischenkreis der Leistungselektronik des Frequenzumrichters, ist an dem Klemmenkasten zumindest ein weiterer Wärmeverteiler vorgesehen, der an einer Innenwandung des Klemmenkastens angeordnet ist und die oben beschriebenen Merkmale aufweist.

Die Erfindung ist nachfolgend anhand von in den Zeichnungen dargestellten Ausführungsbeispielen erläutert. Es zeigen
- Fig. 1: eine Explosionszeichnung eines Klemmenkastens,
- Fig. 2: einen perspektivischen Ausschnitt des Klemmenkastens gemäß Fig. 1 mit einem noch nicht vollständig eingesetzten Wärmeverteiler in einer teilweise geschnittenen Darstellung,
- Fig. 3: einen perspektivischen Ausschnitt des Klemmenkastens gemäß Fig. 1 mit einem an seiner Innenwandung angeordneten Wärmeverteiler in einer teilweise geschnittenen Darstellung und
- Fig. 4: eine Teilschnittansicht des Klemmenkastens gemäß Fig. 1 - 3 mit einem an seiner Innenwandung angeordneten Wärmeverteiler.

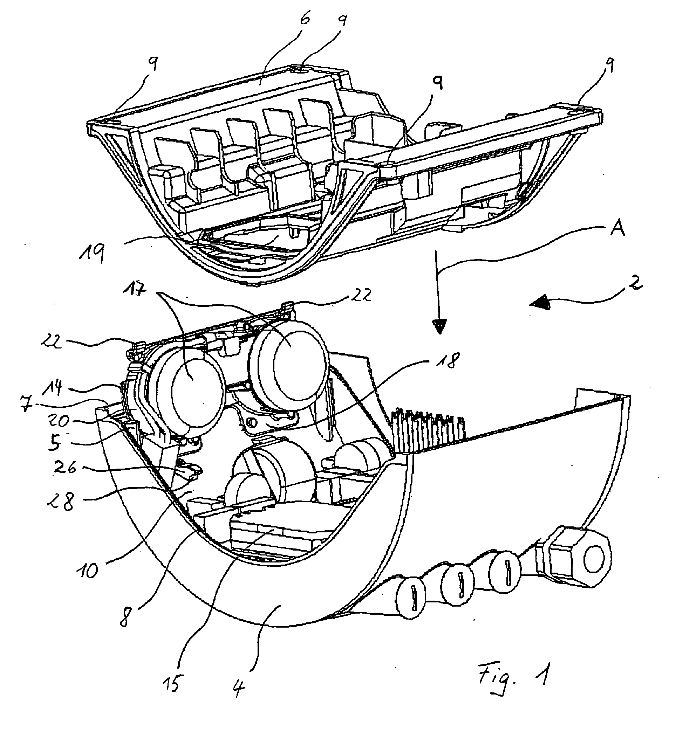

In Fig. 1 ist ein Klemmenkasten 2 explosionsartig dargestellt. Es handelt sich hierbei um einen Klemmenkasten 2 einer Umwälzpumpe. In dem Klemmenkasten 2 ist die Regelungselektronik der Pumpe und insbesondere ein Frequenzumrichter zum Betrieb der Pumpe angeordnet. Der Klemmenkasten 2 besteht aus einem ersten Gehäuseteil 4 und einem zweiten Gehäuseteil 6, die beide als Kunststoffspritzgussteile ausgebildet sind. Das erste Gehäuseteil 4 bildet die von einem Statorgehäuse des Motors abgewandte Außenwand des Klemmenkastens 2. Seine Gestalt ist schalenartig in der Form eines Kreiszylindersegments ausgebildet, wobei er eine von der kreisförmigen Wölbung beabstandete Öffnungsfläche aufweist, welche sich zwischen zwei parallelen Seitenkanten 7 des ersten Gehäuseteils 4 erstreckt. An den beiden Stirnflächen sind am ersten Gehäuseteil 4 zwei von dieser Öffnungsfläche ausgehende große bogenförmige Aussparungen 8 angeordnet. Diese Aussparungen korrespondieren mit der gewölbten Form des zweiten Gehäuseteils 6, welches den Boden des Klemmenkastens 2 bildet und das erste Gehäuseteil 4 an seiner offenen Seite verschließt.

Die beiden Gehäuseteile 4 und 6 werden an einer Fügekante, welche von den Kanten der Aussparungen 8 sowie den zwei diese verbindenden parallelen Seitenkanten 7 des ersten Gehäuseteil 4 gebildet wird, zusammengefügt, wobei die Fügerichtung A, in welcher die Gehäuseteile 4 und 6 zusammengesetzt werden, senkrecht zu der Öffnungsfläche des ersten Gehäuseteils 4 verläuft. Mittels einer Schraubenverbindung werden die beiden Gehäuseteile 4 und 6 fest verbunden. Hierzu sind im Inneren des ersten Gehäuseteils 4 an dessen äußeren Ecken Schraubenaufnahmekanäle 5 angegossen, deren Längsachsen sich in der Fügerichtung A erstrecken und die fluchtend zu vier Durchbrechungen 9 zur Aufnahme der Verbindungsschrauben am zweiten Gehäuseteil 6 angeordnet sind.

Der Klemmenkasten 2 wird mit der konkaven Seite des zweiten Gehäuseteils 6, welche dem Gehäuseteil 4 abgewandt ist, an dem Statorgehäuse des Motors (hier nicht gezeigt) der Umwälzpumpe angeordnet. Die Befestigung des Klemmenkastens 2 an dem Statorgehäuse erfolgt über eine Schraubenverbindung zwischen dem ersten Gehäuseteil 4 und dem Statorgehäuse des Motors. Dabei durchdringen die Befestigungsschrauben das zweite Gehäuseteil 6.

In seinem Inneren weist das erste Gehäuseteil 4 eine Innenwandung 10 auf, welche an ihrem der Scheitellinie des ersten Gehäuseteils 4 zugewandten Ende, d.h. den Kanten der Öffnung abgewandten Ende, durch eine ebene Fläche 12 begrenzt wird. Diese schneidet den teilkreisförmigen Querschnitt des ersten Gehäuseteils 4 in Form einer Sehne und verläuft parallel zur Öffnungsfläche des ersten Gehäuseteils 4.

Die Fläche 12 teilt das erste Gehäuseteil 4 und bildet neben dem Innenraum des Klemmenkastens 2 einen im Scheitelbereich des Gehäuseteils 4 angeordneten Anschlussraum 11 für die Klemmkontakte der elektrischen Versorgungsleitungen. Dieser Anschlussraum 11 ist über eine in der Umfangswandung des Scheitelbereichs des ersten Gehäuseteils 4 integrierte aufschwenkbare Klappe (hier nicht gezeigt) von außen zugänglich.

An der dem Innenraum des Klemmenkastens 2 zugewandten Seite der Fläche 12 ist eine Platine 13 angeordnet. Auf dieser sind Bauteile der Motorelektronik sowie eine Wärmeableitplatte 15, an der die Wärme erzeugende Leistungselektronik des Frequenzumrichters angeordnet ist, befestigt. Das zweite Gehäuseteil 6 weist eine Aussparung 19 auf, welche in ihren Abmessungen den Abmessungen der Wärmeleitplatte 15 entspricht. Im zusammengebauten Zustand des Klemmenkastens 2 ragt die Wärmeableitplatte 15 durch die Aussparung 19 an der konkaven Seite des zweiten Gehäuseteils 6 aus dem Klemmenkasten 2 heraus und liegt nach der Anbindung des Klemmenkastens 2 an dem Statorgehäuse des Motors an, so dass die Wärme der Wärmeableitplatte 15 bzw. die Wärme der an dieser angeordneten Wärme erzeugenden Komponenten in den flüssigkeitsgekühlten Motor abgeführt werden kann.

An einem sich ausgehend von einer der Seitenkanten 7 erstreckenden Bereich der Innenwandung 10 des ersten Gehäuseteils 4 liegt ein Wärmeverteiler 14 an. An diesem sind die Spulen 16 eines Zwischenkreises des Frequenzumrichters angeordnet. Der Abschnitt der Innenwandung 10, an dem der Wärmeverteiler 14 anliegt, ist gewölbt und schräg zur Fügerichtung A der beiden Gehäuseteile 4 und 6 angeordnet, so dass der Wärmeverteiler 14 beim Einsetzen in das erste Gehäuseteil 4 an der Innenwandung 10 in seine vorgesehene Position gleiten kann. Die Anlagefläche 18 des Wärmeverteilers 14, welche an der Innenwandung 10 anliegt, ist komplementär zur gewölbten Fläche der Innenwandung 10 geformt und liegt an dieser flächig und ebenfalls schräg zur Fügerichtung A an. Fig. 1 zeigt den Wärmeverteiler 14 während des Einsetzens, d.h. er ist noch nicht vollständig in das erste Gehäuseteil 4 eingesetzt.

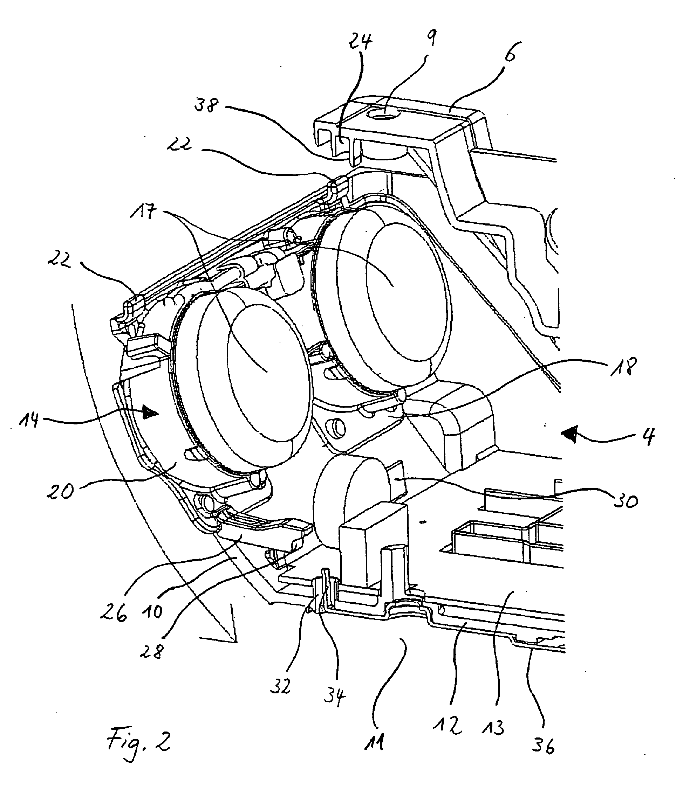

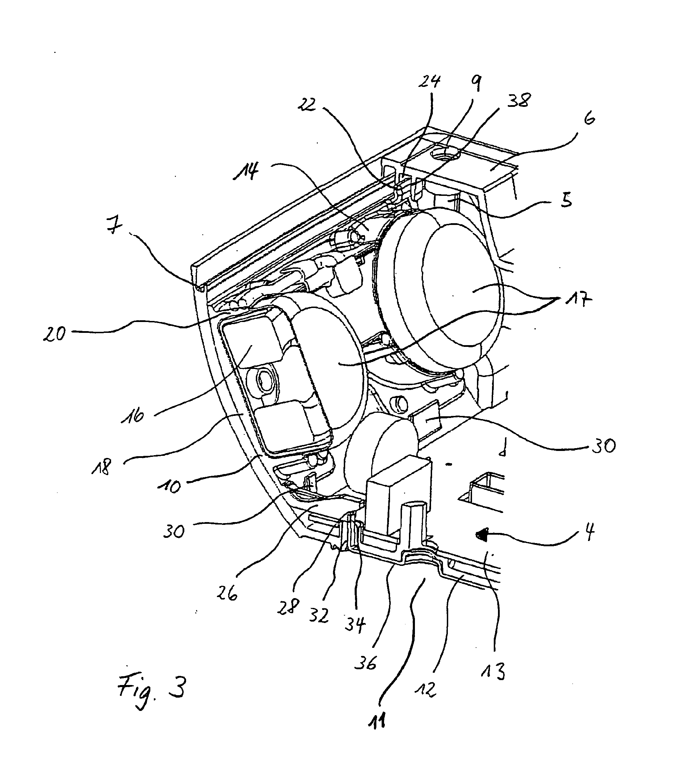

Die Fig. 2 und 3 zeigen einen perspektivischen Ausschnitt des Klemmenkastens 2, wobei der Wärmeverteiler 14 in Fig. 2 während des Einsetzens und in Fig. 3 in seinem eingebauten Zustand dargestellt ist.

Der Wärmeverteiler 14 besteht aus der gewölbten Anlagefläche 18, die an der Innenwandung 10 des ersten Gehäuseteils 4 anliegt. Normal zu dieser Anlagefläche 18 ist an ihrer konkaven, d.h. der Innenwandung 10 abgewandten Seite ein im Wesentlichen umfänglicher Steg 20 angeordnet, der eine geschlossene Wandung eines Aufnahmebereichs der Spulen 16 und des Spulengehäuses 17 bildet. Der von dem Steg 20 gebildete Aufnahmebereich ist an seinen beiden Enden dergestalt erweitert, dass er die Spulen 16 bzw. deren Spulengehäuse 17 kreisförmig umschließt. Gemeinsam mit der Anlagefläche 18 und den Spulengehäusen 17 bildet der Steg 20 eine elektromagnetische Abschirmung der Spulen 16.

An dem der Seitenkante 7 an der Innenwandung 10 des ersten Gehäuseteils 4 zugewandten Ende der Anlagefläche 18 des Wärmeverteilers 14 sind zwei beabstandete, nasenförmig auskragende Halteelemente 22 ausgebildet, die im eingebauten Zustand im Wesentlichen in der Fügerichtung A der beiden Gehäuseteile 4 und 6 verlaufen. Die Halteelemente 22 dienen zum Eingriff in korrespondierende Aufnahmeelemente 24 am zweiten Gehäuseteil 6.

An dem den Halteelementen 22 entgegengesetzten Ende des Wärmeverteilers 14 ist an der konkaven Fläche der Anlagefläche 18 ein armförmiger Kontaktbereich 26 zur Erdung des Wärmeverteilers 14 vorgesehen. In der dargestellten Gestaltungsform erstreckt sich der Arm 26 des Kontaktbereichs von der Anlagefläche 18 des Wärmeverteilers 14 derart in das Innere des Klemmenkastens 2, d.h. von der Innenwandung 10 weg, dass seine Längsachse im eingebauten Zustand des Wärmeverteilers 14 parallel zur Fläche 12 des ersten Gehäuseteils 4 und normal zur Fügerichtung A von erstem und zweiten Gehäuseteil 4 und 6 verläuft. An dem von der Anlagefläche 18 beabstandeten Ende des Armes 26 ist eine Aussparung vorgesehen, wodurch eine Kontaktfläche 28, die senkrecht zur Fläche 12 verläuft, gebildet wird. Der Wärmeverteiler 14 ist als metallisches Gussteil ausgebildet, so dass die Anlagefläche 18, der Steg 20, die Halteelemente 22 und der armförmige Kontaktbereich 26 als ein Bauteil gießtechnisch hergestellt werden können, ohne dass eine weitere Bearbeitung erforderlich ist.

Der Bereich der Innenwandung 10, an dem der Wärmeverteiler 14 anliegt, weist beabstandet von der Seitenkante 7 nahe der Fläche 12 zwei Aufnahmeelemente 30 zur Abstützung des Wärmeverteilers 14 auf. Diese sind stegförmig ausgebildet und erstrecken sich in einer Richtung senkrecht zur Fläche 12 parallel zur Fügerichtung A. Zusammen mit der Innenwandung 10 bilden die Aufnahmeelemente 30 zwei spitze Kehlen, in die der Wärmeverteiler 14 nach dem Einsetzen mit einer Kante seiner Anlagefläche 18 eingreift und sich an diesen abstützt, während er mit seiner Anlagefläche 18 an der Innenwandung 10 des ersten Gehäuseteils 4 anliegt.

An der Fläche 12 ist in der Nähe der Innenwandung 10 eine Durchbrechung 32 vorgesehen. Durch diese ist der Kontakt 34 eines Schutzleiters geführt, der mit einem auf der dem Innenraum und dem zweiten Gehäuseeil 6 abgewandten Seite der Fläche 12 im Anschlussraum 11 angeordneten Erdungsblech 36 verbunden ist. Dieses ist ein rostfreies Stahlblech, welches zur Erdung verschiedener Bauteile der Elektronik bzw. Pumpe dient. An dem Erdungsblech 36 ist eine Anschlussklemme für einen elektrischen Schutzleiter einer Anschlussleitung angeordnet. Ferner ist an dem Erdungsblech 36 eine Durchbrechung 37 vorgesehen. Durch diese und eine komplementäre Durchbrechung in der Fläche 12 und der Platine 13 kann eine Erdungsschraube geführt werden, um Bauteile der Platine 13 zu erden. Ferner liegen die Schrauben zur Befestigung des Klemmenkastens 2 an dem Statorgehäuse an dem Erdungsblech 36 an, sodass über das Erdungsblech 36 und die Schrauben auch das Statorgehäuse geerdet wird.

Der Kontakt 34 ist als Vorsprung des Erdungsbleches 36 ausgebildet, welcher im Wesentlichen normal abgewinkelt und durch die Durchbrechung 32 in das Innere des Klemmenkastens 2 geführt ist, so dass er ausgehend von der Fläche 12 in das Innere des Klemmenkastens 2 hineinragt. Der Kontakt 34 ist aufgrund seiner Abmessungen und seines Materials in einer Richtung normal zu seiner Längsachse federnd ausgebildet und ist so zum einen in der Lage, Wärmedehnungen, Fertigungsungenauigkeiten etc. des Wärmeverteilers 14 bzw. dessen Kontaktbereichs 26 auszugleichen, und kann zum anderen bei Anlage der Kontaktflläche 28 eine Vorspannung erzeugen, die den Erdungskontakt zwischen dem Arm 26 und dem Kontakt 34 sicherstellt. Fig. 3 verdeutlicht, dass der Arm 26 des Wärmeverteilers 14 im eingebauten Zustand mit seiner Kontaktfläche 28 an den Kontakt 34 angedrückt wird und an diesem anliegt. Auf diese Weise ist der Wärmeverteiler 14 geerdet und besitzt wegen der starren Ausbildung des Armes 26 eine weitere Abstützung an dem ersten Gehäuseteil 4.

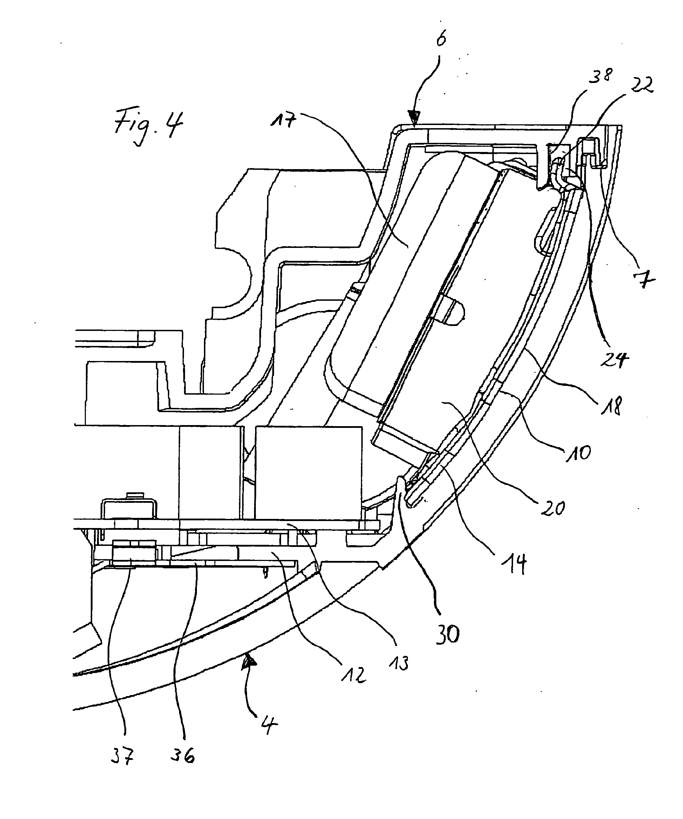

In den Fig. 3 und 4 ist der Wärmeverteiler 14 zwischen den beiden Gehäuseteilen 4 und 6 eingebaut dargestellt. An einer Umfangskante, die der dem Wärmeverteiler 14 benachbarten Seitenkante 7 des ersten Gehäuseteils 4 zugewandt ist, weist das zweite Gehäuseteil 6 zwei Aufnahmeelemente 24 auf, in die die Halteelemente 22 des Wärmeverteilers 14 eingreifen. Die Aufnahmeelemente 24 sind napfartig ausgebildet, zu dem ersten Gehäuseteil 4 hin geöffnet und erstrecken sich in der Fügerichtung A der beiden Gehäuseteile 4 und 6, was das Zusammenfügen des Wärmeverteilers 14 mit den Gehäuseteilen 4 und 6 erleichtert. Dabei weisen die Aufnahmeelemente 24 jeweils eine Seitenfläche 38 auf, die dem Bereich der Innenwandung 10 des ersten Gehäuseteils 4, an welchem der Wärmeleiter 14 anliegt, zugewandt ist. Im zusammengebauten Zustand der beiden Gehäuseteile 4 und 6 drückt diese Seitenfläche 38 gegen einen Bereich einer der Innenwandung 10 abgewandten Seite des Halteelements 22 des Wärmeverteilers 14. Der Wärmeverteiler 14 wird so an die Innenwandung 10 des ersten Gehäuseteils 4 gezwungen, so dass er flächig an dieser anliegt. Um das Halteelement 22 des Wärmeverteilers 14 möglichst spielfrei aufzunehmen, kann das Aufnahmeelement 24 zusätzlich eine elastische Auskleidung aufweisen, die beispielsweise in Form einer Dichtung in dem Aufnahmeelement 24 angeordnet ist. Mögliche Fertigungstoleranzen oder Wärmedehnungen des Wärmeverteilers 14 und seines Halteelements 22 können so ausgeglichen werden. Die Dichtung kann beispielsweise einstückig mit einer zwischen den ersten und zweiten Gehäuseteilen 4 und 6 angeordneten Umfangsdichtung ausgebildet sein.

Bei der Montage des Klemmenkastens 2 gleitet der Wärmeverteiler 14 entlang der Innenwand 10 des ersten Gehäuseteils 4 bis zu den Aufnahmeelementen 30. In der Kehle zwischen der Innenwandung 10 und den Aufnahmeelementen 30 stützt er sich ab und liegt aufgrund seiner mit der Innenwandung 10 korrespondierenden Anlagefläche 18 in dieser Position flächig an der Innenwand 10 an. Gleichzeitig drückt der armförmige Kontaktbereich 26 mit seiner Kontaktfläche 28 gegen den an der Fläche 12 angeordneten Kontakt 34 des Schutzleiters, so dass wegen der elastischen Auslenkung des Kontakts 34 und der Andruckkraft die der Wärmeverteiler 14 über den Arm 26 auf den Kontakt 34 ausübt, eine zuverlässige Kontaktierung sichergestellt ist. Durch das Aufsetzen des zweiten Gehäuseteils 6 auf die Fügekante des ersten Gehäuseteils 4, greifen die Halteelemente 22 des Wärmeverteilers 14 in die napfförmigen Aufnahmeelemente 24 und die von der Innenwandung 10 abgewandten Seiten der Halteelemente 22 kommen in Kontakt mit den Seitenflächen 38 der Aufnahmeelemente 24. Durch diese Kontaktpaarung, die entweder direkt kraftschlüssig oder durch die Anlage an einer Dichtung im Aufnahmeelement 24 zwischen dem Halteelement 22 und der Seitenfläche 38 des Aufnahmeelements 24 erfolgt, wird auf den Wärmeverteiler 14 durch das Zusammendrücken der Gehäuseteile 4 und 6 eine Druckkraft in Richtung der Innenwandung 10 des ersten Gehäuseteils 4 ausgeübt, die den Wärmeverteiler 14 bündig an die Innenwandung 10 zwingt. Gleichzeitig wird der Wärmeverteiler 14 durch den Kraftschluss zwischen Aufnahmeelement 24 und Halteelement 22 oder eine entsprechende formschlüssige Anlage dieser Elemente in der Fügerichtung A zwischen den Gehäuseteilen 4 und 6 eingeklemmt, so dass der Wärmeverteiler 14 spielfrei an der Innenwandung 10 des ersten Gehäuseteils 4 festgelegt ist und ein optimaler Wärmeübergang zwischen Wärmeverteiler 14 und dem ersten Gehäuseteil 4 durch die bündige Anlage des Wärmeverteilers 14 gewährleistet ist. Die Montage des Wärmeverteilers 14 in dem Klemmenkasten 2 ist also denkbar einfach, da sie nur aus dem losen Einlegen des Wärmeverteilers 14 in das erste Gehäuseteil 4 und dem anschließenden Aufsetzen des zweiten Gehäuseteils 6 auf das erste Gehäuseteil 4 besteht. Eine zusätzliche Befestigung des Wärmeleiters 14 in einem zusätzlichen Montageschritt ist nicht erforderlich.

### Bezugszeichenliste

- 2: Klemmenkasten
- 4: erstes Gehäuseteil
- 5: Schraubenaufnahmekanal
- 6: zweites Gehäuseteil
- 7: Seitenkanten
- 8: Ausnehmung
- 9: Durchbrechung
- 10: Innenwandung
- 11: Anschlussraum
- 12: Fläche
- 13: Platinenplatte
- 14: Wärmeverteiler
- 15: Wärmeableitplatte
- 16: Spule
- 17: Spulengehäuse
- 18: Anlagefläche
- 19: Aussparung
- 20: Steg
- 22: Halteelement
- 24: Aufnahmeelement
- 26: Kontaktbereich, Arm
- 28: Kontaktfläche
- 30: Aufnahmeelement
- 32: Durchbrechung
- 34: Kontakt
- 36: Erdungsblech
- 37: Durchbrechung
- 38: Seitenfläche

- A: Fügerichtung

## Patentansprüche

1. Klemmenkasten (2) für einen Elektromotor, wobei der Klemmkasten (2) ein erstes Gehäuseteil (4), ein zweites Gehäuseteil (6) sowie einen Wärmeverteiler (14) aufweist, **dadurch gekennzeichnet, dass** der Wärmeverteiler (14) lose zwischen den Gehäuseteilen eingelegt und ohne weitere Befestigungsmittel derart durch das erste und zweite Gehäuseteil (4, 6) gehalten ist, dass der Wärmeverteiler (14) flächig an einer Innenwandung (10) des ersten Gehäuseteils (4) anliegt.

2. Klemmenkasten (2) nach Anspruch 1, **dadurch gekennzeichnet, dass** die Wandung des ersten Gehäuseteils (4), an welcher der Wärmeverteiler (14) anliegt, schräg zur Fügerichtung (A), in welcher das erste Gehäuseteil (4) und das zweite Gehäuseteil (6) zum Zusammenfügen aufeinander zu bewegt werden, verläuft.

3. Klemmenkasten (2) nach einem der vorhergehenden Ansprüche, **dadurch gekennzeichnet, dass** das erste und zweite Gehäuseteil (4, 6) jeweils zumindest ein Aufnahmeelement (24, 30) zum Halten des Wärmeverteilers (14) aufweisen.

4. Klemmenkasten (2) nach einem der vorhergehenden Ansprüche, **dadurch gekennzeichnet, dass** die Aufnahmeelemente (24, 30) der beiden Gehäuseteile (4, 6) so voneinander beabstandet sind, dass der Wärmeverteiler (14), wenn das erste und zweite Gehäuseteil (4, 6) zusammengesetzt sind, form- und/oder kraftschlüssig an die Gehäusewandung angedrückt wird.

5. Klemmenkasten (2) nach einem der vorhergehenden Ansprüche, **dadurch gekennzeichnet, dass** der Wärmeverteiler (14) zumindest ein Halteelement (22) aufweist, welches mit zumindest einem Aufnahmeelement (24, 30) eines der Gehäuseteile (4, 6) derart in Eingriff ist, dass das Halteelement (22) an einer der innenwandung (10) des ersten Gehäuseteils (4) zugewandten Fläche (38) des Aufnahmeelements (24, 30) anliegt.

6. Klemmenkasten (2) nach einem der vorhergehenden Ansprüche, **dadurch gekennzeichnet, dass** sich das Aufnahmeelement (24) an dem zweiten Gehäuseteil (6) in Fügerichtung (A) der beiden Gehäuseteile (4, 6) erstreckt.

7. Klemmenkasten (2) nach einem der vorhergehenden Ansprüche, **dadurch gekennzeichnet, dass** das Aufnahmeelement (30) am ersten Gehäuseteil (4) von dessen Fügekante (7) mit dem zweiten Gehäuseteil (6) beabstandet ist.

8. Klemmenkasten (2) nach einem der vorhergehenden Ansprüche, **dadurch gekennzeichnet, dass** in einem der Gehäuseteile (4, 6) ein vorzugsweise federnd ausgebildeter Kontakt (34) eines elektrischen Schutzleiters angeordnet ist, an welchem ein Kontaktbereich (26) des Wärmeverteilers (14) anliegt.

9. Klemmenkasten (2) nach Anspruch 8, **dadurch gekennzeichnet, dass** der Kontaktbereich (26) des Wärmeverteilers (14) als Arm ausgebildet ist, welcher sich quer zur Fügerichtung (A) von erstem und zweiten Gehäuseteil (4. 6) erstreckt.

10. Klemmenkasten (2) nach einem der vorhergehenden Ansprüche, **dadurch gekennzeichnet, dass** sich der Wärmeverteiler (14) an der Innenwandung (10) des ersten Gehäuseteils (4) anliegend an dem Aufnahmeelement (30) und dem Kontakt (34) des elektrischen Schutzleiters an einem der Gehäuseteile (4, 6) abstützt.

11. Klemmkasten (2) nach einem der vorangehenden Ansprüche, **dadurch gekennzeichnet, dass** der Klemmenkasten (2) Teil eines nasslaufenden Motors eines Pumpenaggregats bildet.

## Claims

1. A terminal box (2) for an electric motor, wherein the terminal box (2) comprises a first housing part (4), a second housing part (6) as well as a heat distributor (14), **characterised in that** the heat distributor (14) is applied in a loose manner between the housing parts and is held without further fastening means by way of the first and second housing part (4, 6) in a manner such that the heat distributor (14) bears on an inner wall (10) of the first housing part (4) in a surfaced manner.

2. A terminal box (2) according to claim 1, **characterised in that** the wall of the first housing part (4), on which the heat distributor (14) bears, runs obliquely to the joint direction (A), in which the first housing part (4) and the second housing part (6) are moved to one another for joining together.

3. A terminal box (2) according to one of the preceding claims, **characterised in that** the first and the second housing part (4, 6) in each case comprise at least one receiver element (24, 30) for holding the heat distributor (14).

4. A terminal box (2) according to one of the preceding claims, **characterised in that** the receiver elements (24, 30) of the two housing parts (4, 6) are distanced to one another such that the heat distributor (14), when the first and the second housing parts (4, 6) are put together, is pressed onto the housing wall with a positive fit and/or non-positive fit.

5. A terminal box (2) according to one of the preceding claims, **characterised in that** the heat distributor (14) comprises at least one holding element (22), which is engaged with at least one receiver element (24, 30) of one of the housing parts (4, 6), in a manner such that the holding element (22) bears on a surface (38) of the receiver element (24, 30), said surface (38) facing the inner wall (10) of the first housing part (4).

6. A terminal box (2) according to one of the preceding claims, **characterised in that** the receiver element (24) extends on the second housing part (6) in the joint direction (A) of the two housing parts (4, 6).

7. A terminal box (2) according to one of the preceding claims, **characterised in that** the receiver element (30) on the first housing part (4) is distanced to the joint edge (7) of this with the second housing part (6).

8. A terminal box (2) according to one of the preceding claims, **characterised in that** a preferably resiliently designed contact (34) of an electrical protective conductor is arranged in one of the housing parts (4, 6), on which contact a contact region (26) of the heat distributor (14) bears.

9. A terminal box (2) according to claim 8, **characterised in that** the contact region (26) of the heat distributor (14) is designed as an arm, which extends transversely to the joint direction (A) of the first and second housing part (4, 6).

10. A terminal box (2) according to one of the preceding claims, **characterised in that** the heat distributor (14), bearing on the inner wall (10) of the first housing part (4), is supported on the receiver element (30) and the contact (34) of the electrical protective conductor, on one of the housing parts (4, 6).

11. A terminal box (2) according to one of the preceding claims, **characterised in that** the terminal box (2) forms part of a wet-running motor of a pump assembly.

## Revendications

1. Boîte à bornes (2) pour un moteur électrique, la boîte à bornes (2) présentant une première partie de boîtier (4), une deuxième partie de boîtier (6) ainsi qu'un dissipateur de chaleur (14), **caractérisée en ce que** le dissipateur de chaleur (14) est inséré de manière amovible entre les parties de boîtier et est maintenu sans autre moyen de fixation par la première et la seconde partie de boîtier (4, 6) de façon telle que le dissipateur de chaleur (14) s'appuie en étendue contre une paroi intérieure (10) de la première partie de boîtier (4).

2. Boîte à bornes (2) selon la revendication 1, **caractérisée en ce que** la paroi de la première partie de boîtier (4) contre laquelle s'appuie le dissipateur de chaleur (14), s'étend de manière oblique par rapport à la direction d'assemblage (A), dans laquelle la première partie de boîtier (4) et la deuxième partie de boîtier (6) sont déplacées l'une vers l'autre pour être réunies.

3. Boîte à bornes (2) selon l'une des revendications précédentes, **caractérisée en ce que** la première et la deuxième partie de boîtier (4, 6) présentent respectivement au moins un élément de logement (24, 30) pour retenir le dissipateur de chaleur (14).

4. Boîte à bornes (2) selon l'une des revendications précédentes, **caractérisée en ce que** les éléments de logement (24, 30) des deux parties de boîtier (4, 6) sont éloignés les uns des autres de façon telle que le dissipateur de chaleur (14), lorsque la première et la deuxième partie de boîtier (4, 6) sont assemblées, est serré par complémentarité de forme et/ou par adhérence contre la paroi du boîtier.

5. Boîte à bornes (2) selon l'une des revendications précédentes, **caractérisée en ce que** le dissipateur de chaleur (14) présente au moins un élément de retenue (22) qui est en prise avec au moins un élément de logement (24, 30) de l'une des parties de boîtier (4, 6) de façon telle que l'élément de retenue (22) s'appuie contre une surface (38) de l'élément de logement (24, 30) tournée vers la paroi intérieure (10) de la première partie de boîtier (4).

6. Boîte à bornes (2) selon l'une des revendications précédentes, **caractérisée en ce que** l'élément de logement (24) sur la deuxième partie de boîtier (6) s'étend dans la direction d'assemblage (A) des deux parties de boîtier (4, 6).

7. Boîte à bornes (2) selon l'une des revendications précédentes, **caractérisée en ce que** l'élément de logement (30) sur la première partie de boîtier (4) est éloigné du bord d'assemblage (7) de celle-ci avec la deuxième partie de boîtier (6).

8. Boîte à bornes (2) selon l'une des revendications précédentes, **caractérisée en ce qu'**est disposé dans l'une des parties de boîtier (4, 6) un contact (34) de préférence élastique d'un conducteur de protection électrique, contre lequel s'appuie une région de contact (26) du dissipateur de chaleur (14).

9. Boîte à bornes (2) selon la revendication 8, **caractérisée en ce que** la région de contact (26) du dissipateur de chaleur (14) est conçue sous la forme d'un bras qui s'étend transversalement à la direction d'assemblage (A) de la première et de la deuxième partie de boîtier (4, 6).

10. Boîte à bornes (2) selon l'une des revendications précédentes, **caractérisée en ce que** le dissipateur de chaleur (14) s'appuie contre la paroi intérieure (10) de la première partie de boîtier (4) de manière adjacente à l'élément de logement (30) et au contact (34) du conducteur de protection électrique sur l'une des parties de boîtier (4, 6).

11. Boîte à bornes (2) selon l'une des revendications précédentes, **caractérisée en ce que** la boîte à bornes (2) constitue une partie d'un moteur à fonctionnement par voie humide d'un groupe motopompe.
